(19) Europäisches Patentamt / European Patent Office / Office européen des brevets

(11) **EP 4 811 991 A1**

(12) **EUROPEAN PATENT APPLICATION**
published in accordance with Art. 153(4) EPC


(43) Date of publication:
**23.09.2026 Bulletin 2026/39**

(21) Application number: **24913356.2**

(22) Date of filing: **20.11.2024**

(51) International Patent Classification (IPC):
***H10K 59/80*** *(2023.01)* ***B29C 39/14*** *(2006.01)*
***B29C 39/38*** *(2006.01)* ***B29C 39/00*** *(2006.01)*
***B29C 70/06*** *(2006.01)* ***C08J 5/18*** *(2006.01)*
***C08K 5/12*** *(2006.01)* ***C08K 7/02*** *(2006.01)*
***C08K 3/22*** *(2006.01)*

(52) Cooperative Patent Classification (CPC):
**B29C 39/00; B29C 39/14; B29C 39/38; B29C 70/06; C08J 5/18; C08K 3/22; C08K 5/12; C08K 7/02; H10K 59/80**

(86) International application number:
**PCT/KR2024/018345**

(87) International publication number:
**WO 2025/143549 (03.07.2025 Gazette 2025/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.12.2023 KR 20230194277**



(71) Applicant: **Kolon Industries, Inc.**
**Seoul 07793 (KR)**

(72) Inventor: **SHIN, In Ho**
**Seoul 07793 (KR)**

(74) Representative: **Ter Meer Steinmeister & Partner Patentanwälte mbB**
**Nymphenburger Straße 4**
**80335 München (DE)**


(54) **OPTICAL FILM HAVING REINFORCED PROTECTION OF BOTTOM LAYER, AND DISPLAY DEVICE COMPRISING SAME**


(57) The present invention provides an optical film and a display device comprising same, the optical film according to an embodiment of the present invention comprising a light-transmitting matrix, and a filler dispersed therein, wherein the filler is in the form of fibers, and with the diameter of the filler being A and length B, B/A is 10-500, and the pressure resistance index of the optical film is 30 or greater with respect to 50μm thickness.


FIG. 1

100
110
120
S2
S1


EP 4 811 991 A1

## Description

[Technical Field]

The present disclosure relates to an optical film and a display device including the same and more particularly, to an optical film having an excellent function of protecting lower layers due to superior pressure resistance.

[Background Art]

Recently, the use of an optical film instead of glass as a cover window of a display device has been considered with the goal of reducing thickness and weight and increasing the flexibility of the display device. In order for the optical film to be usable as a cover window of a display device, the optical film needs to have superior optical properties and excellent mechanical properties. For example, an optical film needs to have properties such as excellent strength, hardness, abrasion resistance, and flexibility.

Fillers may be added in order to impart desired physical properties to an optical film requiring various physical properties. The fillers may vary depending on physical properties required for the optical film.

[Disclosure]

[Technical Problem]

Therefore, the present disclosure has been made in view of the above problems, and it is one aspect of the present disclosure to provide an optical film that includes a fiber- or filament-shaped filler dispersed in a light-transmitting matrix.

It is another aspect of the present disclosure to provide an optical film that includes a fiber- or filament-shaped filler, which is dispersed in a light-transmitting matrix and links polymer chains constituting the light-transmitting matrix to improve the stability and arrangement characteristics of the polymer chains.

It is another aspect of the present disclosure to provide an optical film that includes a fiber- or filament-shaped filler dispersed in a light-transmitting matrix and thus has excellent pressure resistance compared to thickness.

It is yet another aspect of the present disclosure to provide a display device including the optical film.

[Technical Solution]

In accordance with an aspect of the present disclosure, the above and other objects can be accomplished by the provision of an optical film including a light-transmitting matrix and a filler dispersed in the light-transmitting matrix, wherein the filler has a fiber shape, the filler has B/A of 10 to 500, wherein A represents a diameter of the filler and B represents a length of the filler, and the optical film has a pressure resistance index of 30 or more based on a thickness of 50 μm, wherein the pressure resistance index is calculated in accordance with the following Equation 1:

Pressure Resistance Index = Rising point of inflection of differential hardness / Thickness [Equation 1]

wherein the differential hardness is obtained by disposing an optical film with a size of 26 mm X 76 mm on a glass substrate with the same size as the optical film, placing an adhesive layer between the glass substrate and the optical film to form a laminate sample, measuring a depth-dependent indentation hardness at five points on a surface of the optical film when a force gradually increasing up to 2,000 mN is applied using a nanoindenter in a vertical direction to the surface of the optical film from the surface of the optical film of the laminate sample for 20 seconds, and calculating an average of the measured indentation hardness values; and

the rising point of inflection is a pressing force at a point where the differential hardness starts to rise rapidly in a graph of the differential hardness of the laminate sample.

In an embodiment of the present disclosure, the optical film may have 1 mm dent strength of 11 N or more based on a thickness of 50 μm, wherein the 1 mm dent strength means a force resisted by the optical film against pressing to a depth of 1 mm when the optical film is pressed in a vertical direction at a speed of 5 mm/min using a probe provided in a universal testing machine.

In an embodiment of the present disclosure, the optical film may have 1 mm dent strength of 11 N or more based on a thickness of 50 μm,

wherein the 1 mm dent strength means a force resisted by the optical film against pressing to a depth of 1 mm when the optical film is pressed in a vertical direction at a speed of 5 mm/min using a probe provided in a universal testing machine.

In an embodiment of the present disclosure, the optical film may have B/A of 200 to 400.

In an embodiment of the present disclosure, the filler may have a diameter of 2 nm to 10 nm and a length of 200 nm to 4,000 nm.

In an embodiment of the present disclosure, the filler may include at least one of glass fiber, an aluminum-based fiber, or fluoride fiber. In an embodiment of the present disclosure, a content of the filler may be 1 to 40 wt% based on a total weight of the optical film.

In an embodiment of the present disclosure, the optical film may have a Vickers hardness (HV) of 42.5 or more based on a thickness of 50 μm.

In an embodiment of the present disclosure, the optical film may have a yellowness index of 3 or less based on a thickness of 50 μm.

In an embodiment of the present disclosure, the optical film may have a haze of 4% or less based on a thickness of 50 μm.

In an embodiment of the present disclosure, the optical film may have a light transmittance of 88% or more based on a thickness of 50 μm.

In an embodiment of the present disclosure, the light-transmitting matrix may include at least one of an imide repeating unit or an amide repeating unit.

In accordance with another aspect of the present disclosure, there is provided a display device including a display panel and the optical film disposed on the display panel.

In accordance with another aspect of the present disclosure, there is provided a method of manufacturing an optical film including primarily dispersing a filler in a resin solution for forming a polymer matrix to prepare a first mixed solution, adjusting a pH of the first mixed solution to 5 to 7 to improve arrangement characteristics of the filler in the first mixed solution, casting the first mixed solution to prepare a cast film, applying a pressure to the cast film, and drying the cast film while heating at a heating rate of 1°C/1 minute from 80°C to 120°C, wherein the filler has a fiber shape, and the filler has B/A of 10 to 500, wherein A represents a diameter of the filler and B represents a length of the filler.

[Advantageous Effects]

According to one embodiment of the present disclosure, the filler included in the optical film has a fiber or filament shape and can link (entangle) the polymer chains constituting the light-transmitting matrix. As a result, the mechanical strength of the optical film may be improved and in particular, the dent strength of the optical film may be improved.

According to one embodiment of the present disclosure, the optical film has a pressure resistance index of 30 or more and is thus capable of effectively protecting the display device disposed under the optical film and the elements inside the display device when the optical film is disposed on the display device.

The optical film according to one embodiment of the present disclosure includes a fiber- or filament-shaped filler, thereby exhibiting excellent optical properties and mechanical properties.

The optical film according to one embodiment of the present disclosure may have excellent optical properties and mechanical properties and thus may be useful as a cover window of a display device.

[Description of Drawings]

FIG. 1 is a schematic diagram illustrating an optical film according to an embodiment of the present disclosure.

FIG. 2 is an example of a graph showing the result of measurement of differential hardness of the optical film according to one embodiment of the present disclosure and the optical film according to Comparative Example.

FIG. 3 is an example of a graph showing the result of measurement of differential hardness depending on an indentation depth of a laminate sample according to an embodiment of the present disclosure.

FIG. 4 is a cross-sectional view illustrating a part of a display device according to another embodiment of the present disclosure.

FIG. 5 is an enlarged cross-sectional view illustrating part "P" in FIG. 4.

[Best Mode]

Hereinafter, embodiments of the present disclosure will be described in detail with reference to the accompanying drawings. However, the following embodiments are illustratively provided merely for clear understanding of the present disclosure and do not limit the scope of the present disclosure.

The shapes, sizes, ratios, angles, and numbers disclosed in the drawings for describing embodiments of the present disclosure are merely examples, and the present disclosure is not limited to the illustrated details. Like reference numerals refer to like elements throughout the present specification. In the following description, when a detailed description of relevant known functions or configurations is determined to unnecessarily obscure important points of the present disclosure, the detailed description will be omitted.

In the case in which a term such as "comprise", "have", or "include" is used in the present specification, another part may also be present, unless "only" is also used. Terms in a singular form may include the plural meanings, unless noted to the contrary. Also, in construing an element, the element is to be construed as including an error range, although there is no explicit description thereof.

In describing a positional relationship, for example, when the positional relationship is described using "on", "above", "below", or "next to", the case of no contact therebetween may be included, unless "immediately" or "directly" is used.

Spatially relative terms, such as "below", "beneath", "lower", "above", and "upper", may be used herein to describe the relationship between a device or element and another device or element, as shown in the figures. It will be understood that spatially relative terms are intended to encompass different orientations of a device during the use or operation of the device, in addition to the orientation depicted in the figures. For example, if a device in one of the figures is turned upside down, elements described as "below" or "beneath" other elements would then be positioned "above" the other elements. The exemplary term "below" or "beneath" can, therefore, encompass the meanings of both "below" and "above". In the same manner, the exemplary term "above" or "upper" can encompass the meanings of both "above" and "below".

In describing temporal relationships, for example, when a temporal order is described using "after", "subsequent", "next", or "before", the case of a non-continuous relationship may be included, unless "immediately" or "directly" is used.

It will be understood that, although the terms "first", "second", etc. may be used herein to describe various elements, these elements are not limited by these terms. These terms are only used to distinguish one element from another. Therefore, a first element could be termed a second element within the technical idea of the present disclosure.

It should be understood that the term "at least one" includes all combinations related with one or more items. For example, "at least one among a first element, a second element, and a third element" may include all combinations of two or more elements selected from among the first, second, and third elements, as well as each of the first, second, and third elements.

Features of various embodiments of the present disclosure may be partially or completely integrated or combined with each other, and may be variously interoperated with each other and driven technically. The embodiments of the present disclosure may be carried out independently from each other, or may be carried out together in an interrelated manner.

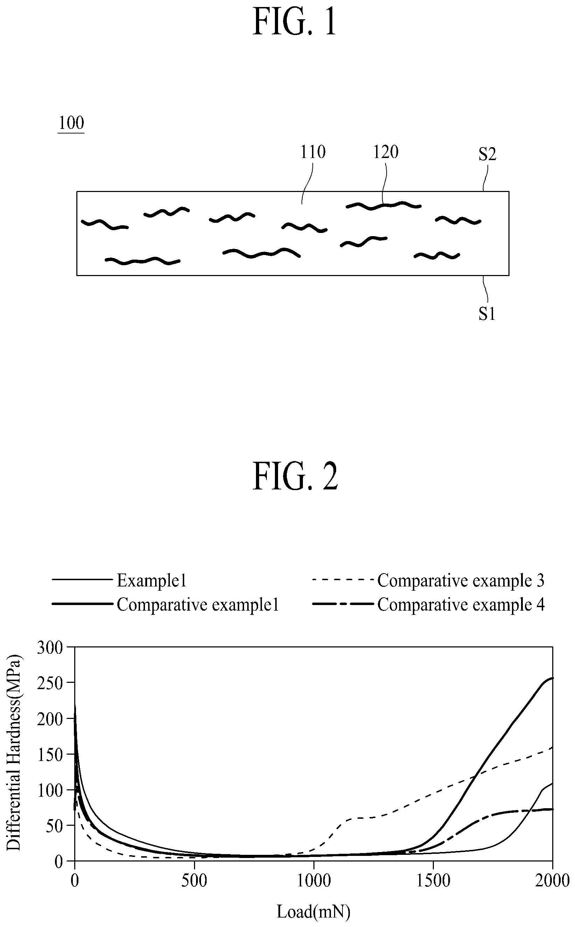

FIG. 1 is a schematic diagram illustrating an optical film 100 according to an embodiment of the present disclosure. According to one embodiment of the present disclosure, a film having light transmittance is referred to as an "optical film 100".

According to one embodiment of the present disclosure, the optical film 100 may have a first surface S1 and a second surface S2 that face each other.

For example, when the optical film 100 is manufactured by casting, the surface of the optical film 100 that contacts the casting substrate may be referred to as a "belt surface". According to one embodiment of the present disclosure, the belt surface of the optical film 100 is referred to as the "first surface S1". In addition, the optical film 100 may have a surface that faces the belt surface, and the surface that faces the belt surface may be referred to as an "air surface". According to one embodiment of the present disclosure, the air surface of the optical film 100 is referred to as the "second surface S2".

The optical film 100 according to an embodiment of the present disclosure includes a light-transmitting matrix 110 and a filler 120 dispersed in the light-transmitting matrix 110.

The light-transmitting matrix 110 may be light-transmitting. According to an embodiment of the present disclosure, the light-transmitting matrix 110 may be flexible. For example, the optical film according to an embodiment of the present disclosure may be bendable, foldable, or rollable. As a result, the optical film 100 according to an embodiment of the present disclosure may be light-transmitting and may be bendable, foldable, or rollable.

According to an embodiment of the present disclosure, the light-transmitting matrix 110 may include at least one of an imide repeating unit or an amide repeating unit.

The light-transmitting matrix 110 according to an embodiment of the present disclosure may be produced from monomer ingredients including diamine and dianhydride. Specifically, the light-transmitting matrix 110 may include an imide repeating unit formed by the dianhydride and the diamine. The light-transmitting matrix 110 having an imide repeating unit may, for example, be a polyimide resin.

However, the light-transmitting matrix 110 according to an embodiment of the present disclosure is not limited thereto and the light-transmitting matrix 110 may be produced from ingredients including a dicarbonyl-based compound

and a diamine-based monomer. Specifically, the light-transmitting matrix 110 may include an amide repeating unit formed by a dicarbonyl-based compound and a diamine-based monomer. The light-transmitting matrix 110 having an imide repeating unit may, for example, be a polyamide resin.

In addition, the light-transmitting matrix 110 according to an embodiment of the present disclosure may be produced from monomer ingredients including a dicarbonyl-based compound in addition to the dianhydride and the diamine. Specifically, the light-transmitting matrix 110 may have an imide repeating unit and an amide repeating unit. For example, the light-transmitting matrix 110 having an imide repeating unit and an amide repeating unit may be a polyamide-imide resin.

According to one embodiment of the present disclosure, the light-transmitting matrix 110 may include a polyimide-based polymer. Examples of the polyimide-based polymer may include polyimide polymers, polyamide-imide polymers and the like. The light-transmitting matrix 110 according to an embodiment of the present disclosure may be produced from, for example, a polyimide-based polymer resin.

According to one embodiment of the present disclosure, the light-transmitting matrix 110 may be formed from a polymerizable composition containing a diamine-based monomer, and at least one of a dianhydride-based compound or a dicarbonyl-based compound.

The polymerizable composition according to an embodiment of the present disclosure may include a diamine-based monomer.

According to an embodiment of the present disclosure, for example, the diamine-based compound may include at least one of m-tolidine, 2,2'-bis(trifluoromethyl)benzidine (TFDB), 4,4'-oxydianiline (ODA), p-phenylenediamine (pPDA), m-phenylenediamine (mPDA), p-methylenediamine (pMDA), m-methylenediamine (mMDA), 1,3-bis(3-aminophenoxy)benzene (133APB), 1,3-bis(4-aminophenoxy)benzene (134APB), 2,2'-bis[4(4-aminophenoxy)phenyl] hexafluoropropane (4BDAF), 2,2'-bis(3-aminophenyl) hexafluoropropane (33-6F), 2,2'-bis(4-aminophenyl) hexafluoropropane (44-6F), bis(4-aminophenyl)sulfone (4DDS), bis(3-aminophenyl)sulfone (3DDS), 1,3-cyclohexanediamine (13CHD), 1,4-cyclohexanediamine (14CHD), 2,2-bis(4-(4-aminophenoxy)phenyl)propane (6HMDA), 2,2-bis(3-amino-4-hydroxyphenyl)hexafluoropropane (DBOH), or 4,4'-bis(3-aminophenoxy)diphenylsulfone (DBSDA).

More specifically, according to an embodiment of the present disclosure, for example, the diamine-based compound may include at least one of m-tolidine, 2,2'-bis(trifluoromethyl)benzidine (TFDB), para-phenylene diamine (pPDA), meta-phenylene diamine (mPDA), para-methylene diamine (pMDA), meta-methylene diamine (mMDA), bis(4-aminophenyl)sulfone (4DDS), bis(3-aminophenyl)sulfone (3DDS), or 4,4'-bis(3-aminophenoxy)diphenylsulfone (DBSDA), but one embodiment of the present disclosure is not limited thereto.

The polymerizable composition according to an embodiment of the present disclosure may include at least one of a dianhydride-based compound or a dicarbonyl-based compound.

According to one embodiment of the present disclosure, the dianhydride-based compound may, for example, include at least one of 4,4'-(4,4-isopropylidenediphenoxy)bis(phthalic anhydride (4IBA), 3,3,4,4-biphenyltetracarboxylic dianhydride (BPDA), 2,2-bis(3,4-dicarboxyphenyl)hexafluoropropane dianhydride (6FDA), cyclobutane-1,2,3,4-tetracarboxylic dianhydride (CBDA), 4-(2,5-dioxotetrahydrofuran-3-yl)-1,2,3,4-tetrahydronaphthalene-1,2-dicarboxylic anhydride (TDA), pyromellitic acid dianhydride (1,2,4,5-benzene tetracarboxylic dianhydride, PMDA), benzophenone tetracarboxylic dianhydride (3,3,4,4-benzophenone tetracarboxylic dianhydride (BTDA), 4,4-oxydiphthalic dianhydride (ODPA), bis(3,4-dicarboxyphenyl)dimethyl-silane dianhydride (SiDA), bis(3,4-dicarboxyphenoxy)diphenyl sulfide dianhydride (BDSDA), or sulfonyldiphthalic anhydride (SO2DPA).

More specifically, according to one embodiment of the present disclosure, the dianhydride-based compound may, for example, include at least one of isopropylidenediphenoxy bisphthalic anhydride (4,4'-(4,4'-isopropylidenediphenoxy)bis(phthalic anhydride, 4IBA), 3,3,4,4-biphenyltetracarboxylic dianhydride (BPDA), 2,2-bis(3,4-dicarboxyphenyl)hexafluoropropane dianhydride (6FDA), cyclobutane-1,2,3,4-tetracarboxylic dianhydride (CBDA), pyromellitic acid dianhydride (1,2,4,5-benzene tetracarboxylic dianhydride, PMDA), 3,3,4,4-benzophenone tetracarboxylic dianhydride (BTDA), or 4,4-oxydiphthalic dianhydride (ODPA), but one embodiment of the present disclosure is not limited thereto.

According to one embodiment of the present disclosure, the dicarbonyl-based compound may, for example, include at least one of terephthaloyl chloride (TPC), phthaloyl chloride, isophthaloyl chloride (IPC), 4,4'-biphenyldicarbonyl chloride (DPDOC), 4,4'-oxybis(benzoyl chloride) (OBBOC), naphthalene-2,3-dicarbonyl dichloride, or 1,4-cyclohexanedicabonyldichloride (CHDOC).

More specifically, according to one embodiment of the present disclosure, the dicarbonyl-based compound may, for example, include at least one of terephthaloyl chloride (TPC), phthaloyl chloride, or isophthaloyl chloride, but one embodiment of the present disclosure is not limited thereto. According to one embodiment of the present disclosure, the total equivalent weight of the dianhydride-based compound and the dicarbonyl-based compound may be substantially the same as the equivalent weight of the diamine-based monomer.

The light-transmitting matrix 110 may have a thickness sufficient for the optical film 100 to protect the display panel. For example, the light-transmitting matrix 110 may have a thickness of 10 to 100 $\mu$m. The thickness of the light-transmitting matrix 110 may be the same as that of the optical film 100.

The filler 120 may have a fiber shape. The fiber may mean, for example, a material, the length of which is

significantly longer than a diameter thereof. The fiber may mean a material that is long and thin like a thread. The fiber may mean a material that has a linear structure. The fiber may also mean a material that is long and bendable.

Hereinafter, a shape having a length greater than a diameter is referred to as a "fiber shape". The fiber shape may also be referred to as a "filament shape". According to one embodiment of the present disclosure, the length of the filler 120 may be more than twice the diameter thereof.

According to one embodiment of the present disclosure, the filler 120 is arranged in parallel with the polymer resin contained in the light-transmitting matrix 110. For example, the filler 120 may be bound to the main chain of the polymer resin through a secondary bond such as a hydrogen bond or a dipole moment, and may be arranged in parallel with the main chain in the same direction as in the main chain.

According to one embodiment of the present disclosure, the filler 120 has a fiber shape and thus can link the polymer chains constituting the light-transmitting matrix 110. As a result, the stability and arrangement characteristics of the polymer chains can be improved, the mechanical properties of the light-transmitting matrix 110 can be improved, and the mechanical properties of the optical film 100 can also be improved.

According to one embodiment of the present disclosure, the filler 120 may have B/A of 10 to 500 wherein A represents a diameter of the filler 120 and B represents a length of the filler 120.

When the ratio of the length to the diameter of the filler 120 (B/A) is less than 10, the function of the filler 120 to link the polymer chains may not be sufficiently exerted due to insufficient length of the filler 120, and the pressure resistance of the optical film 100 may be insufficient because the effect of improving the stability and arrangement characteristics of the polymer chains is not sufficiently exerted.

When the ratio of the length to the diameter of the filler 120 (B/A) is greater than 500, the filler 120 may reduce the dispersibility of the filler 120 and cause agglomeration of the filler 120 within the light-transmitting matrix 110 due to excessively great length. As a result, the optical film 100 may have decreased light transmittance, increased haze and deteriorated optical properties. In addition, the mechanical strength of the optical film 100 may decrease in the area where agglomeration of the filler 120 occurs.

According to one embodiment of the present disclosure, the ratio of the length to the diameter of the filler 120 (B/A) is for example, in the range of 50 to 500. More specifically, the ratio of the length to the diameter of the filler 120 (B/A) may be in the range of, for example, 100 to 400, and may be in the range of 200 to 400. The ratio of the length to the diameter of the filler 120 (B/A) may be in the range of 300 to 400.

According to one embodiment of the present disclosure, when the ratio of the length to the diameter of the filler 120 is 200 or more, the pressure resistance of the optical film 100 may be further improved. Meanwhile, when the ratio of the length to the diameter of the filler 120 is 400 or less, the pressure resistance of the optical film 100 may be improved and a decrease in optical properties may be prevented.

According to one embodiment of the present disclosure, the filler 120 may have a diameter of 2 nm to 10 nm and a length of 200 nm to 4,000 nm.

According to one embodiment of the present disclosure, the diameter and length of the filler 120 may be measured with a transmission electron microscope (TEM).

When the diameter of the filler 120 is less than 2 nm, the stability of the filler 120 may be decreased and it may be difficult to improve the pressure resistance of the optical film 100 due to the lack of ability to link the polymer chains with each other. In addition, the filler 120 may be cut or broken, thus causing contamination of the optical film 100 and increasing the haze of the optical film 100.

When the diameter of the filler 120 is higher than 10 nm, the filler 120 has difficulty in having a fiber shape, the function of the filler 120 to link the polymer chains may be deteriorated, the effect of improving the pressure resistance of the optical film 100 may not be sufficiently obtained, and the optical film 100 may have decreased transmittance.

When the length of the filler 120 is less than 200 nm, the function of the filler 120 to link the polymer chains may not be sufficiently exerted and it may be difficult to improve the effect of improving the pressure resistance of the optical film 100.

When the length of the filler 120 is higher than 4,000 nm, the dispersibility of the filler 120 may decrease, and as a result, agglomeration of the filler 120 may occur within the light-transmitting matrix 110 and thus the effect of improving the pressure resistance of the optical film 100 may not be uniform throughout the film. In addition, the optical film 100 may have decreased light transmittance and increased haze.

There is no particular limitation on the type of filler 120. Any filler may be used without limitation as the filler 120 according to an embodiment of the present disclosure so long as it has a fiber shape. The filler 120 may be inorganic or organic. The filler 120 may include at least one of inorganic fibers, organic fibers, or organic-inorganic hybrid fibers.

More specifically, the filler 120 may have a fiber shape. For example, the filler 120 may have a single-stranded fiber shape, a multi-stranded fiber shape, or a branch shape in which multiple strands are arranged in the form of branches based on one central strand.

According to one embodiment of the present disclosure, the filler 120 may include at least one of glass fiber, an aluminum-based fiber, or fluoride fiber.

The glass fiber may contain $SiO_2$ and may further contain other components in addition to $SiO_2$. The aluminum-based fiber contains aluminum oxide hydroxide. The aluminum-based fiber may further contain other components in addition to aluminum oxide hydroxide. The fluoride fiber may contain at least one of polytetrafluoroethylene (PTFE) or polyvinylidene fluoride (PVDF) and may further contain other components in addition to PTFE and PVDF.

According to one embodiment of the present disclosure, the filler 120 may include at least one of aluminum oxide hydroxide, $SiO_2$, PTFE (polytetrafluoroethylene), or polyvinylidene fluoride (PVDF).

According to one embodiment of the present disclosure, the filler 120 may include an aluminum-based fiber. The aluminum-based fiber may include aluminum oxide hydroxide.

According to one embodiment of the present disclosure, the filler 120 may include aluminum oxide hydroxide. Aluminum oxide hydroxide is also called "Boehmite" and may be represented by γ-AlO(OH). More specifically, aluminum oxide hydroxide may include a structure represented by any of the following Formulas 1, 2, and 3.

[Formula 1]

[Formula 2]

H
O
Al
O
m

[Formula 3]

H
O
O
Al
Al
O
O
H
p

wherein n ranges from 50 to 10,000, m ranges from 50 to 10,000, and p ranges from 100 to 20,000.

When the structures of Formulas 1, 2 and 3 are expanded for better understanding of the structure of the filler 120, the filler 120 may be represented by any one of Formulas 4, 5 and 6.

The structure represented by Formula 1 may be represented by, for example, Formula 4 below. Formula 4 below corresponds to the structure of Formula 1 wherein n is 5.

[Formula 4]

OH
O
Al
*

The structure represented by Formula 2 may be represented by, for example, Formula 5 below. Formula 5 below corresponds to the structure of Formula 2 wherein m is 4.

[Formula 5]

The structure represented by Formula 3 may be represented by, for example, Formula 6 below. Formula 6 below corresponds to the structure of Formula 3 wherein p is 3.

[Formula 6]

In Formulas 4 to 6, "*" represents a binding position.

According to one embodiment of the present invention, $SiO_2$ may have a unit structure represented by the following Formula 7.

According to one embodiment of the present disclosure, the filler 120 may be surface-treated. For example, the filler 120 may be surface-treated with an organic compound group having an alkoxy group.

According to an embodiment of the present disclosure, the filler 120 may cause appropriate light scattering to improve the optical properties of the optical film 100. To enhance the light scattering effect, the content of the filler 120 in the optical film 100 may be adjusted.

According to one embodiment of the present disclosure, the content of the filler 120 may be 1 to 40 wt%, based on the total weight of the optical film 100.

When the content of the filler 120 is less than 1 wt%, based on the total weight of the optical film 100, the effect of improving the light transmittance of the optical film 10 cannot be obtained because the light scattering effect by the filler 120 is insufficient, and the optical film 100 cannot sufficiently exert the effect of improving pressure resistance because the function of the filler 120 to link the polymer chains is not sufficiently exerted.

On the other hand, when the content of the filler 120 is higher than 40 wt%, based on the total weight of the optical film 100, the dispersibility of the filler 120 may decrease, the mechanical properties may decrease, and agglomeration of the filler 120 may occur due to the excessive amount of the filler 120, thus causing deterioration in haze of the optical film 100. The agglomerated filler 120 blocks light, which may reduce the light transmittance of the optical film 100.

More specifically, the content of the filler 120 with respect to the total weight of the optical film 100 may be adjusted to 3 to 40 wt%, may be adjusted to 5 to 40 wt%, may be adjusted to 5 to 30 wt%, and may also be adjusted to 5 to 20 wt%.

According to one embodiment of the present disclosure, by adjusting the diameter, length, and content of the filler 120 and improving the dispersion method, the pressure resistance of the optical film 100 may be improved while an increase in haze and a decrease in light transmittance of the optical film 100 may be prevented.

According to one embodiment of the present disclosure, the optical film 100 may have an MD (machine direction) and a TD (transverse direction).

The direction in which mechanical treatment is applied to the film is referred to as "machine direction (MD)" and the direction perpendicular to the machine direction (MD) is referred to as "transverse direction (TD)". For example, when tension is applied to the film, the direction parallel to the tension direction may be the machine direction (MD), and when the film is cast, the direction parallel to the casting direction may be the machine direction (MD), and when the film is wound through a roller, the direction parallel to the winding direction may be the machine direction (MD).

According to one embodiment of the present disclosure, the machine direction MD is a direction parallel to the casting direction of the optical film 100 during the manufacturing process of the optical film. The MD may be referred to as a "length direction". The transverse direction (TD) is a direction perpendicular to the MD. The transverse direction (TD) may be referred to as a "width direction".

According to one embodiment of the present disclosure, the filler 120 may have a fiber shape and may be dispersed while oriented in a predetermined direction within the light-transmitting matrix 110. More specifically, the filler 120 may be oriented in the machine direction MD or the transverse direction TD.

According to one embodiment of the present disclosure, the optical film 100 may have a pressure resistance index of 30 or more based on a thickness of 50 μm.

The pressure resistance index is a numerical representation of the ability to prevent or suppress damage to a lower component (e.g., a panel or pixel) of the optical film 100 by an external force such as pressure (pressing) when the optical film 100 is disposed on a display device, and is calculated in accordance with Equation 1 below. The unit of the pressure resistance index is defined as mN/μm.

Pressure Resistance Index = Rising point of inflection of differential hardness / Thickness [Equation 1]

FIG. 2 is an example of a graph showing the result of measurement of differential hardness of the optical film 100 according to one embodiment of the present disclosure and the optical film according to Comparative Example.

In Equation 1, differential hardness means an indentation hardness at a specific depth (thickness) (depth-dependent indentation hardness) of the optical film 100 that changes depending on indentation when an object, for example, the optical film 100 is pressed by an external force. The differential hardness is defined as MPa.

Differential hardness may be measured by indenting the optical film 100 to a predetermined depth using, for example, a nanoindenter. For example, an HM-2000 from Fisher may be used as the nanoindenter.

More specifically, on a glass substrate with a size of 26 mm X 76 mm X 1T, an optical film 100 of the same area as the glass substrate is disposed and an adhesive layer is placed between the glass substrate and the optical film 100 to form a laminate sample. Then, when a force gradually increases up to 2,000 mN in the vertical direction of the surface of the optical film from the surface of the optical film of the laminate sample using a nanoindenter for 20 seconds, the depth-dependent indentation hardness is measured at five points on the surface of the optical film 100, for example, in the center of the optical film 100 and at points 1 mm apart from the center of the optical film 100 in up, down, left and right directions, and an average of the obtained values is defined as "differential hardness".

OCA (optically clear adhesive, #8146-2) with a thickness of 50 $\mu$m from 3M may be used as an adhesive layer used to produce the laminate sample for measuring the differential hardness, for example.

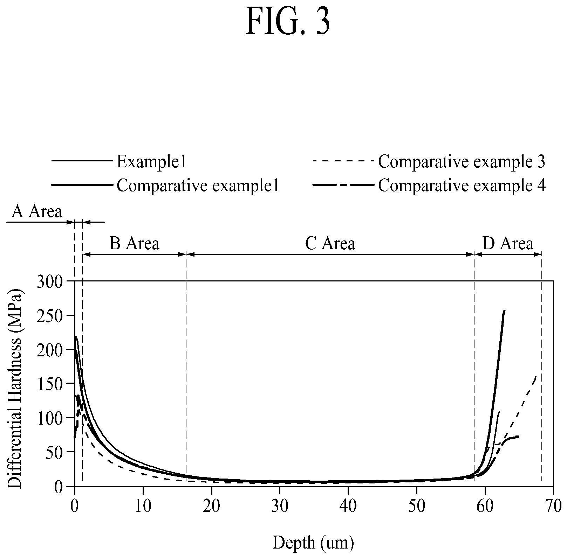

FIG. 3 is an example of a graph showing the result of measurement of differential hardness depending on the indentation depth of the laminate sample according to an embodiment of the present disclosure.

In general, when a laminate having a structure in which organic polymer layers having different mechanical properties, for example, different hardness, are laminated, such as the laminate sample, is pressed by an external force, a relatively soft organic polymer layer is pressed first. When the pressing of the relatively soft organic polymer layer is completed, a relatively hard organic polymer layer is then pressed. At this time, as the pressing resistance of the relatively hard organic polymer layer increases, the external force required until the relatively soft organic polymer layer is completely pressed increases.

As can be seen from FIG. 3, when the laminate sample having a laminate structure is pressed by an external force, in region A, the external force is applied to the optical film disposed on the surface of the laminate sample and the optical film begins to be pressed. In region B, a relatively soft (low hardness) adhesive layer is pressed along with the optical film. Then, in the region C, only the adhesive layer is pressed until the entire adhesive layer is pressed, and in the D region, the optical film part is pressed again.

As can be seen from FIG. 2, the rising point of inflection in Equation 1 means a pressing force (mN) at the point where the differential hardness starts to rise rapidly in the differential hardness measurement graph of the laminate sample. More specifically, the rising point of inflection means a pressing force (mN) at the point where the differential hardness starts to rise rapidly (for example, at the point of 15 MPa) after reaching the lowest point (for example, 10 MPa or less) in the differential hardness measurement graph.

It can be seen from FIG. 2 that the rising point of inflections of the laminate samples manufactured using the optical film 100 according to one embodiment of the present disclosure and the optical film according to Comparative Example are different from each other.

The rising point of inflections are different between the optical films because respective films have different mechanical properties, for example, different pressing resistance, due to the difference in composition therebetween and thus have also different buffering effects against external force. More specifically, the polyimide-based polymer resin has better hardness than the polyethylene terephthalate (PET) resin and thus has superior pressure resistance against external force. Accordingly, it can be seen that the rising point of inflection of the differential hardness of the optical film 100 according to one embodiment of the present disclosure is formed at a high point compared to the polyethylene terephthalate (PET) film.

The fact that the rising point of inflection of the differential hardness is formed at a high point means, for example, that the optical film 100, which is the upper layer in the laminate sample, has a high pressing resistance, and that the force applied until the lower layer, i.e., the adhesive layer, is completely pressed is great. Therefore, as the rising point of inflection of the differential hardness is formed at a higher point, the ability to protect the lower layer increases and thus the pressure resistance index increases.

According to one embodiment of the present disclosure, the optical film 100 has a pressure resistance index of 30 or more and thus has the excellent ability to protect the display device disposed under the optical film and the element inside the display device, for example, when the optical film 100 is disposed on the display device.

When the pressure resistance index of the optical film 100 is less than 30, for example, the ability of the optical film 100 to protect the display device disposed under the optical film and the element inside the display device may be insufficient although the optical film 100 is disposed on the display device.

The optical film 100 according to an embodiment of the present disclosure may have a 1 mm dent strength of 11 N or more based on 50 μm. The basic unit of 1 mm dent strength is N.

The term "1 mm dent strength" may be defined as the force of the optical film 100 to resist compression in a vertical direction to a depth of 1 mm from a point where a force of 1 N is applied.

The 1 mm dent strength is an indicator of the surface hardness of the optical film 100. An excellent 1 mm dent strength means high pressure resistance to external force.

The 1 mm dent strength may be measured, for example, as follows: first, the optical film 100 according to an embodiment of the present disclosure is produced into a sample with a size of 60 mm x 60 mm. The produced sample for the optical film 100 is placed on a fixture with a circular hole in the center and then the sample for the optical film 100 is fixed with a clamp. The sample for the optical film 100 is pressed with a probe having a cylindrical head with a diameter of 1.59 mm mounted on a universal testing machine in the vertical direction at a speed of 5 mm/min. The force measured upon pressing from the point where a force of 1 N is applied to the probe as a reference point to a depth of 1 mm may be measured as the 1 mm dent strength of the optical film 100. For example, a universal testing machine from Instron Corporation, fixture (S1-11855), clamp and probe (2830-005) may be used to measure the 1 mm dent strength.

When the 1 mm dent strength of the optical film 100 is less than 11 N, for example, when the optical film 100 is used as a cover window of a display device, indentations, scratches, or the like may be formed on the cover window by external force generated from a touch pen, fingernail, foreign matter, or the like, which may deteriorate the exterior quality of the cover window.

The optical film 100 according to an embodiment of the present disclosure may have a Vickers hardness (HV) of 42.5 or more based on a thickness of 50 μm.

The Vickers hardness (HV) of the optical film 100 according to an embodiment of the present disclosure is obtained by pressing the optical film 100 using a diamond pyramid and measuring the surface hardness of the indentations created. The Vickers hardness of the optical film was obtained by calculating HV = C/D wherein C is a pressing load (kg) and D is a surface area ($mm^2$). Vickers hardness was measured using an HM-2000 from Fisher Scientific International, Inc. as a Vickers hardness tester.

When the Vickers hardness of the optical film 100 is less than 42.5, the optical film 100 may be vulnerable to external indentations. For example, when an external force is applied to the outside of the optical film 100, the optical film 100 may be readily scratched or cracked.

According to one embodiment of the present disclosure, the optical film 100 may have a yellowness index of 3 or less based on a thickness of 50 μm.

According to one embodiment of the present disclosure, although the optical film 100 includes a filler 120 having a diameter-to-length ratio (B/A) of 10 to 500, the filler 120 is uniformly dispersed within the optical film 100 and has a predetermined range of orientation, whereby the yellowness index of the optical film 100 does not increase significantly and thus the optical properties do not deteriorate. More specifically, the optical film 100 may include a filler 120 having a diameter-to-length ratio (B/A) of 100 to 400. Even in this case, the yellowness index of the optical film 100 does not increase significantly and thus the optical properties do not deteriorate.

According to one embodiment of the present disclosure, the optical film 100 may have a haze of 4% or less based on a thickness of 50 μm, and more specifically, may have a haze of 1% or less. Although the length of the filler 120 included in the light-transmitting matrix 110 is relatively great, the diameter of the filler 120 is small and thus an increase in haze due to the filler 120 may be prevented. In particular, by using a fiber-shaped filler 120, adjusting the diameter, length, diameter-to-length ratio (B/A) and content ratio of the filler 120 dispersed in the light-transmitting matrix 110, and improving the dispersibility of the filler 120, a haze of 4% or less, and for example, a haze of 1% or less can be imparted to the optical film 100.

In addition, according to one embodiment of the present disclosure, the optical film 100 may have a light transmittance of 88% or more based on a thickness of 50 μm. The length of the filler 120 included in the light-transmitting matrix 110 is relatively great, but the diameter of the filler 120 is small. Therefore, a decrease in the light transmittance due to the filler 120 can be prevented. In particular, by using a fiber-shaped filler 120, adjusting the diameter, length, diameter-to-length ratio (B/A) and content ratio of the filler 120 dispersed in the light-transmitting matrix 110, and improving the dispersibility of the filler 120, a light transmittance of 88% or more can be imparted to the optical film 100.

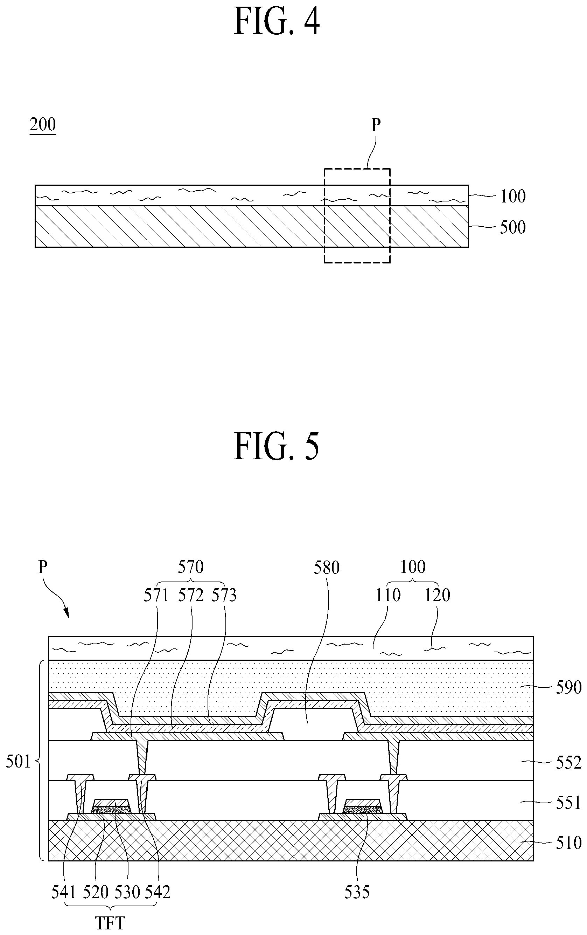

FIG. 4 is a cross-sectional view illustrating a part of a display device 200 according to another embodiment of the present disclosure and FIG. 5 is an enlarged cross-sectional view of "P" in FIG. 4.

Referring to FIG. 4, the display device 200 according to another embodiment of the present disclosure includes a display panel 501 and an optical film 100 on the display panel 501.

Referring to FIGs. 4 and 5, the display panel 501 includes a substrate 510, a thin film transistor TFT on the substrate 510, and an organic light-emitting device 570 connected to the thin film transistor TFT. The organic light-emitting device 570 includes a first electrode 571, an organic light-emitting layer 572 on the first electrode 571, and a second electrode 573 on the organic light-emitting layer 572. The display device 200 shown in FIGs. 4 and 5 is an organic light-emitting display device.

The substrate 510 may be formed of glass or plastic. Specifically, the substrate 510 may be formed of plastic such as a polyimide-based resin or an optical film. Although not shown, a buffer layer may be disposed on the substrate 510.

The thin film transistor TFT is disposed on the substrate 510. The thin film transistor TFT includes a semiconductor layer 520, a gate electrode 530 that is insulated from the semiconductor layer 520 and at least partially overlaps the semiconductor layer 520, a source electrode 541 connected to the semiconductor layer 520, and a drain electrode 542 that is spaced apart from the source electrode 541 and is connected to the semiconductor layer 520.

Referring to FIG. 5, a gate insulating layer 535 is disposed between the gate electrode 530 and the semiconductor layer 520. An interlayer insulating layer 551 may be disposed on the gate electrode 530, and the source electrode 541 and the drain electrode 542 may be disposed on the interlayer insulating layer 551.

A planarization layer 552 is disposed on the thin film transistor TFT to planarize the top of the thin film transistor TFT.

A first electrode 571 is disposed on the planarization layer 552. The first electrode 571 is connected to the thin film transistor TFT through a contact hole provided in the planarization layer 552.

A bank layer 580 is disposed on the planarization layer 552 in a part of the first electrode 571 to define pixel areas or light-emitting areas. For example, the bank layer 580 is disposed in the form of a matrix at the boundaries between a plurality of pixels to define the respective pixel regions.

The organic light-emitting layer 572 is disposed on the first electrode 571. The organic light-emitting layer 572 may also be disposed on the bank layer 580. The organic light-emitting layer 572 may include one light-emitting layer, or two or more light-emitting layers stacked in a vertical direction. Light having any one color among red, green, and blue may be emitted from the organic light-emitting layer 572, and white light may be emitted therefrom.

The second electrode 573 is disposed on the organic light-emitting layer 572.

The first electrode 571, the organic light-emitting layer 572, and the second electrode 573 may be stacked to constitute the organic light-emitting device 570.

Although not shown, when the organic light-emitting layer 572 emits white light, each pixel may include a color filter for filtering the white light emitted from the organic light-emitting layer 572 based on a particular wavelength. The color filter is formed on the light path.

A thin-film encapsulation layer 590 may be disposed on the second electrode 573. The thin-film encapsulation layer 590 may include at least one organic layer and at least one inorganic layer, and the at least one organic layer and the at least one inorganic layer may be alternately disposed.

The optical film 100 is disposed on the display panel 501 having the stack structure described above. The optical film 100 includes a light-transmitting matrix 110 and a filler 120 dispersed in the light-transmitting matrix 110.

Hereinafter, a method of manufacturing an optical film 100 according to another embodiment of the present disclosure will be described.

The method of manufacturing an optical film 100 according to one embodiment of the present disclosure may include primarily dispersing a filler 120 in a resin solution for forming a polymer matrix 110 to prepare a first mixed solution, improving the orientation characteristics of the filler 120 in the first mixed solution, and casting the first mixed solution to prepare a cast film.

According to one embodiment of the present disclosure, a polyimide-based resin solution may be used as the resin solution for forming a polymer matrix 110.

More specifically, the method of manufacturing an optical film 100 according to one embodiment of the present disclosure may include preparing a polyimide-based resin powder, dissolving the polyimide-based resin powder in a first solvent to prepare a polyimide-based resin solution, dispersing the filler 120 in a second solvent to prepare a filler dispersion, and mixing the filler dispersion with the polyimide-based resin solution to prepare a first mixed solution.

DMAc (N,N-dimethylacetamide) may be used as the first solvent. DMAc (N,N-dimethylacetamide) or methyl ethyl ketone (MEK) may be used as the second solvent. However, one embodiment of the present disclosure is not limited thereto and other known solvents may be used as the first solvent and the second solvent.

A fiber-shaped filler 120, for example, a fiber-shaped filler 120 having a large aspect ratio, has a great length relative to its diameter and thus may easily be entangled or agglomerated within the light-transmitting matrix. Therefore, the filler 120 requires excellent dispersibility within the first mixed solution.

According to one embodiment of the present disclosure, to improve the dispersibility of the filler 120, for example, toluene sulfonic acid (p-toluene sulfonic acid, PTSA) may be used as an additive. However, embodiments of the present disclosure are not limited thereto and other known additives may be used to improve the dispersibility of the filler 120.

According to one embodiment of the present disclosure, in order to improve the dispersibility of the filler 120, the pH of the first mixed solution may be adjusted. For example, the pH of the first mixed solution may be adjusted to a range of 5 to 7. Accordingly, the agglomeration or aggregation of the filler 120 may be prevented.

Then, the first mixed solution is cast, dried and heat-treated to form an optical film 100. According to one embodiment of the present disclosure, the film formed by casting the first mixed solution may be referred to as a "cast film" and the film produced by drying and heat-treating the cast film may be referred to as an "optical film 100". The cast film may

be referred to as an "uncured film".

In order to improve the orientation of the filler 120, casting may be performed by bar coating.

According to one embodiment of the present disclosure, the orientation direction and orientation degree of the filler 120 may be changed by controlling the pressure applied to the cast film formed by casting.

In addition, convection may be prevented during drying and heat treatment of the cast film formed by casting, so that the filler 120 may be oriented in a predetermined direction.

Specifically, when convection is generated inside the cast film that is dried using heat, the orientation of the filler 120 may decrease. Thus, the cast film may be allowed to be dried slowly to prevent convection. For example, drying of the cast film may be performed while raising the temperature from 80°C to 120°C at a rate of 1°C/1 min. When drying is performed over a predetermined level, the orientation of the filler 120 may be fixed.

Hereinafter, the present disclosure will be described in more detail with reference to Preparation Examples and Examples. However, the following Preparation examples and Examples should not be construed as limiting the scope of the present disclosure.

<Preparation Example 1: Preparation of polyimide-based polymer solid>

800.50 g of N,N-dimethylacetamide (DMAc) was charged in a 1L reactor equipped with a stirrer, a nitrogen injector, a dropping funnel, a temperature controller, and a cooler while the reactor was purged with nitrogen. Then, the temperature of the reactor was adjusted to 25°C and 29.796 g (0.12 mol) of bis(3-aminophenyl)sulfone) (3DDS) was completely dissolved therein. After complete dissolution of 3DDS, 25.476 g (0.12 mol) of m-tolidine was added thereto and completely dissolved therein, and the resulting solution was maintained at 25°C. 62.459 g (0.12 mol) of 4IBA (4,4'-(4,4'-isopropylidenediphenoxy)bis(phthalic anhydride)) was added thereto and completely dissolved while stirring for 3 hours and then 23.533 g (0.12 mol) of CBDA (cyclobutane-1,2,3,4-tetracarboxylic dianhydride) was added thereto and completely dissolved therein. Polymerization was sufficiently performed at 25°C for 12 hours to obtain a polymer solution having a solid concentration of 12 wt%.

9.49 g of pyridine and 12.25 g of acetic anhydride were added to the obtained polymer solution, and the resulting mixture was stirred for 30 minutes, stirred again at 70°C for 1 hour, and then allowed to cool to room temperature. 20 L of methanol was added to the obtained polymer solution to precipitate a solid, and the precipitated solid was filtered, pulverized, washed again with 2 L of methanol, and dried under vacuum at 100°C for 6 hours to obtain a polyimide-based polymer solid as a powder. The polyimide polymer solid prepare herein was a polyamide-imide polymer solid.

<Preparation Example 2: Preparation of polyimide-based polymer solid>

765.09 g of N,N-dimethylacetamide (DMAc) was charged in a 1L reactor equipped with a stirrer, a nitrogen injector, a dropping funnel, a temperature controller, and a cooler while the reactor was purged with nitrogen. Then, the temperature of the reactor was adjusted to 25°C and 18.16 g (168 mol) of meta-phenylene diamine (mPDA) was completely dissolved therein. 15.28 g (0.072 mol) of m-tolidine was added thereto and completely dissolved therein and the resulting solution was maintained at 25°C. 87.44 g (0.168 mol) of 4,4'-(4,4'-isopropylidenediphenoxy)bis(phthalic anhydride) (4IBA) was added thereto and completely dissolved while stirring for 3 hours. The temperature of the reactor was decreased to 10°C and 14.12 g (0.072 mol) of terephthaloyl chloride (TPC) was added thereto and reacted at 25°C for 12 hours to obtain a polymer solution having a solid concentration of 15 wt%.

9.49 g of pyridine and 12.25 g of acetic anhydride were added to the obtained polymer solution, and the resulting mixture was stirred for 30 minutes, stirred again at 70°C for 1 hour, and then allowed to cool to room temperature. 20 L of methanol was added to the obtained polymer solution to precipitate a solid, and the precipitated solid was filtered, pulverized, washed again with 2 L of methanol, and dried under vacuum at 100°C for 6 hours to obtain a polyimide-based polymer solid as a powder.

<Example 1>

850 g of DMAc (first solvent) was added to a 1 L reactor and the reactor was stirred for a predetermined period of time while the temperature of the reactor was maintained at 10°C. Then, 127 g of polyamide-imide (polyimide-based resin powder) prepared as the solid powder in Preparation Example 1 was added to the reactor, stirred for 1 hour, and heated to 25°C to prepare a polyimide-based resin solution.

An aluminum oxide hydroxide fiber dispersion was used to add the filler 120. Specifically, an aluminum oxide hydroxide fiber dispersion prepared by dispersing an aluminum oxide hydroxide fiber having an average diameter of about 4 nm and an average length of about 1,600 nm at 10 wt% in a DMAc (N,N-dimethylacetamide) solution (second solvent) was used. The content of the filler 120 was 10 wt% based on the total weight of the solid (polyimide-based resin component + filler).

Specifically, the aluminum oxide hydroxide fiber dispersion was charged into another 1 L reactor and the prepared liquid polyimide-based resin solution was slowly injected for 1 hour using a cylinder pump, while the temperature of the reactor was maintained at 25°C, to prepare a first mixed solution in which the aluminum oxide hydroxide fiber dispersion was mixed with the polyimide-based resin solution. Here, the filler 120 is an aluminum oxide hydroxide fiber represented by Formula 1.

The pH of the first mixed solution measured immediately after preparation was 8 or higher. In order to improve the arrangement characteristics of the filler 120, a weak acid such as acetic acid was added to the first mixed solution to adjust the pH of the first mixed solution to a range of 5 to 7. The first mixed solution thus prepared was a polyimide-based resin solution in which the fiber-shaped filler 120 is dispersed.

The obtained first mixed solution was cast. A casting substrate was used for casting. At this time, there is no particular limitation on the type of the casting substrate. The casting substrate may be a glass substrate, a stainless steel (SUS) substrate, a Teflon substrate, or the like. According to one embodiment of the present disclosure, a glass substrate was used as the casting substrate.

Specifically, the obtained first mixed solution was applied to a glass substrate and cast. In order to improve the orientation of the filler 120, the first mixed solution was applied to a glass substrate (casting substrate) and then cast while applying a force of 30 N in a direction perpendicular to the glass substrate. As a result, a cast film was produced.

Specifically, the cast film was produced by slowly drying in a hot air oven at 80°C up to 120°C at a rate of 1°C/min for about 40 minutes to maintain the orientation of the filler 120. Then, the produced film was peeled off of the glass substrate and fixed to a frame with pins.

The frame to which the optical film was fixed was slowly heated in a vacuum oven from 100°C to 280°C for 2 hours, cooled slowly and separated from the frame to obtain an optical film. The optical film was heated again at 250°C for 5 minutes.

As a result, an optical film 100 having a thickness of 50 μm and including the light-transmitting matrix 110 and the filler 120 dispersed in the light-transmitting matrix 110 was completed.

<Examples 2 to 5>

The optical films 100 were produced under the conditions of Table 1 in the same manner as in Example 1 and are referred to as "Examples 2 to 5".

<Example 6>

An optical film 100 was manufactured under the conditions of Table 1 in the same manner as in Example 1, except that the polyimide-based resin of the solid powder prepared in Preparation Example 2 was used instead of the polyimide-based resin of the solid powder prepared in Preparation Example 1 and this optical film 100 is referred to as "Example 6".

<Comparative Examples 1 to 2>

Optical films 100 were manufactured under the conditions of Table 1 in the same manner as in Example 1 and are referred to as Comparative Examples 1 to 2.

<Comparative Examples 3 and 4>

A 50 μm thick PET film (PET 50, Kolon Industries, Inc.) used as the optical film is referred to Comparative Example 3 and a 65 μm thick PET film (PET 65, Kolon Industries, Inc.) used as an optical film is referred to as Comparative Example 4.

[Table 1]

| Item | Type of base film | Type of filler | Content of filler (wt%) | Length/diameter of filler (B/A) |
|---|---|---|---|---|
| Example 1 | Imide-based | Aluminum oxide hydroxide (Formula 1) | 10 | 400 |
| Example 2 | Imide-based | Aluminum oxide hydroxide (Formula 2) | 10 | 400 |
| Example 3 | Imide-based | Aluminum oxide hydroxide (Formula 3) | 10 | 400 |
| Example 4 | Imide-based | Aluminum oxide hydroxide (Formula 1) | 5 | 400 |
| Example 5 | Imide-based | Aluminum oxide hydroxide | 20 | 400 |

(continued)

| Item | Type of base film | Type of filler | Content of filler (wt%) | Length/diameter of filler (B/A) |
|---|---|---|---|---|
| | | (Formula 1) | | |
| Example 6 | Imide-based | Aluminum oxide hydroxide (Formula 1) | 10 | 400 |
| Comparative Example 1 | Imide-based | Not added | - | - |
| Comparative Example 2 | Imide-based | Silica | 10 | 1 |
| Comparative Example 3 | PET | Not added | - | - |
| Comparative Example 4 | PET | Not added | - | - |
| Alumina oxide hydroxide: aluminum oxide hydroxide fiber dispersion<br>Silica: spherical nano-silica with particle size ranging from 10 to 20 nm | | | | |

<Measurement of physical properties>

The following physical properties of the optical films manufactured in Examples 1 to 6 and Comparative Examples 1 to 4 were measured.

(1) Measurement of Vickers hardness (HV)

The optical films manufactured in Examples 1 to 6 and Comparative Examples 1 to 4 were pressed with a diamond pyramid whose opposite faces meet at the apex at an angle of 136 degrees in accordance with ISO 14577-1, and the surface hardness of the indentation formed was measured. The Vickers hardness of the optical film was obtained by calculating HV = C/D wherein C is a pressing load (kg) and D is a surface area ($mm^2$). Vickers hardness was measured using an HM-2000 from Fisher Scientific International, Inc. as a Vickers hardness tester.

- Force: 12 mN
- Running Time: 12 s
- Hold Time: 5 s

(2) Measurement of Differential hardness of Film

The differential hardness of each of optical films manufactured according to Examples 1 to 6 and Comparative Examples 1 to 4 was measured as follows.

On a glass substrate measuring 26 mm X 76 mm X 1T, each of the optical films manufactured according to Examples 1 to 6 and Comparative Examples 1 to 4 having the same area as the glass substrate was placed and an adhesive layer (50 μm thick OCA, 3M) was placed between the glass substrate and the optical film to form a laminate sample. Then, while a force gradually increases up to 2,000 mN in the vertical direction of the surface of the optical film using a nanoindenter from the surface of the optical film of the laminate sample for 20 seconds, the depth-dependent indentation hardness is measured at five points on the surface of the optical film 100 (in the center of the optical film 100 and at points 1 mm apart from the center of the optical film 100 in up, down, left, and right directions), and the average of the obtained values is defined as "differential hardness".

(3) Measurement of pressure resistance index

The differential hardness of each of the optical films with a thickness of 50 μm manufactured according to Examples 1 to 6 and Comparative Examples 1 to 4 was measured as in (2) above, and a graph for the average was obtained. Then, the pressing force (load, mN) at 15 MPa, which is the point where the differential hardness starts to rise rapidly after reaching 10 MPa or lower in the differential hardness measurement value graph, was set as the rising point of inflection, which was obtained by calculating in accordance with Equation 1 below.

Pressure Resistance Index = Rising point of inflection of differential hardness / Thickness [Equation 1]

(4) Measurement of 1 mm dent strength

An optical film sample with a size of 60 mm X 60 mm was produced from each of the optical films manufactured according to Examples 1 to 6 and Comparative Examples 1 to 4. The produced optical film sample was placed on a fixture having a circular hole in the center thereof and then the sample for the optical film 100 was fixed with a clamp. The sample for the optical film 100 was pressed using a probe having a cylindrical head with a diameter of 1.59 mm mounted on a universal testing machine in the vertical direction from the surface of the optical film sample at a speed of 5 mm/min. The force applied to the probe measured while the optical film sample was pressed with the probe to a depth of 1 mm from the point where a force of 1N is applied to the probe as a base point is defined as the 1 mm dent strength of the optical film 100.

(5) Measurement of yellowness index

The yellowness index of each of the optical films with a thickness of 50 μm manufactured according to Examples 1 to 6 and Comparative Examples 1 to 4 was measured using a spectrophotometer (CM-3700D from Konica Minolta) in accordance with ASTM E313.

(6) Measurement of haze

Optical film samples with a size of 50 mm x 50 mm were produced from the optical films having a thickness of 50 μm manufactured in Examples 1 to 6 and Comparative Examples 1 to 4, and the haze of each optical film sample was measured using a haze meter (HM-150, Murakami) in accordance with ASTM D1003.

(7) Measurement of light transmittance (%)

The light transmittance at a wavelength of 360 to 740 nm of each of optical films manufactured in Examples 1 to 6 and Comparative Examples 1 to 4 was measured using a spectrophotometer (CM-3700D, Konica Minolta) in accordance with ASTM E313.

The results of measurement are shown in Table 2 below.

[Table 2]

| Item | Rising point of inflection (mN) | Pressure resistance index (mN/μm) | 1 mm dent strength (N) | Vickers hardness | Yellowness index | Haze (%) | Light transmittance (%) |
|---|---|---|---|---|---|---|---|
| Example 1 | 1,687 | 33.8 | 12.4 | 45.8 | 2.8 | 0.3 | 88.6 |
| Example 2 | 1,654 | 33.1 | 12.3 | 45.0 | 2.78 | 0.2 | 88.7 |
| Example 3 | 1,701 | 34.0 | 12.5 | 44.9 | 2.72 | 0.2 | 88.7 |
| Example 4 | 1,560 | 31.2 | 11.3 | 44.9 | 2.8 | 0.2 | 88.6 |
| Example 5 | 1,894 | 37.9 | 12.8 | 47.0 | 2.9 | 0.3 | 88.5 |
| Example 6 | 1,750 | 35.0 | 12.7 | 46.0 | 3.0 | 0.3 | 88.4 |
| Comparative Example 1 | 1,390 | 27.8 | 10.4 | 40.1 | 2.7 | 0.2 | 89.2 |
| Comparative Example 2 | 1,353 | 27.1 | 10.2 | 41.1 | 2.6 | 0.3 | 89.3 |
| Comparative Example 3 | 990 | 19.8 | 7.4 | 24.3 | 0.7 | 1.0 | 91.5 |
| Comparative Example 4 | 1,457 | 22.4 | 9.9 | 24.5 | 1.2 | 1.5 | 91.1 |
| Pressure Resistance Index = Rising point of inflection of differential hardness / Thickness | | | | | | | |

As can be seen from results of measurement in Table 2, the optical films 100 according to Examples 1 to 6 of the present disclosure have a high pressure resistance index of 30 mN/μm or more, a 1 mm dent strength of 11 N or more, and

a Vickers hardness of 42.5 or more, and thus have an excellent ability to prevent or suppress damage to a lower structure due to an external force when the optical film 100 is used as a cover window of the display device. In addition, it can be seen that, even if the optical films 100 contain a fiber-shaped filler 120, the optical properties, such as light transmittance, yellowness, and haze, are not deteriorated.

On the other hand, the optical films according to Comparative Examples 1 to 4 have a pressure resistance index of less than 30 mN/μm, a 1 mm dent strength of less than 11 N, and a Vickers hardness of less than 42.5, and thus have an insufficient ability to prevent or suppress damage to a lower structure due to an external force when the optical film is used as a cover window of a display device.

[Explanation of reference numerals]

100: Optical film
110: Light-transmitting matrix
120: Filler
200: Display device
501: Display panel

## Claims

**1.** An optical film comprising:

a light-transmitting matrix; and
a filler dispersed in the light-transmitting matrix,
wherein the filler has a fiber shape,
the filler has B/A of 10 to 500, wherein the A represents a diameter of the filler and the B represents a length of the filler, and
the optical film has a pressure resistance index of 30 or more based on a thickness of 50 μm,
wherein the pressure resistance index is calculated in accordance with the following Equation 1:

Pressure Resistance Index = Rising point of inflection of differential hardness / Thickness [Equation 1]

wherein the differential hardness is obtained by disposing an optical film with a size of 26 mm X 76 mm on a glass substrate with the same size as the optical film, placing an adhesive layer between the glass substrate and the optical film to form a laminate sample, measuring depth-dependent indentation hardness at five points on a surface of the optical film when a force gradually increasing up to 2,000 mN is applied using a nanoindenter in a vertical direction to the surface of the optical film from the surface of the optical film of the laminate sample for 20 seconds, and calculating an average of the measured indentation hardness values; and
the rising point of inflection is a pressing force at a point where the differential hardness starts to rise rapidly in a graph of the differential hardness of the laminate sample.

**2.** The optical film according to claim 1, wherein the optical film has 1 mm dent strength of 11 N or more based on a thickness of 50 μm,
wherein the 1 mm dent strength means a force resisted by the optical film against pressing to a depth of 1 mm when the optical film is pressed in a vertical direction at a speed of 5 mm/min using a probe provided in a universal testing machine.

**3.** The optical film according to claim 1, wherein the optical film has B/A of 200 to 400.

**4.** The optical film according to claim 1, wherein the filler has a diameter of 2 nm to 10 nm and a length of 200 nm to 4,000 nm.

**5.** The optical film according to claim 1, wherein the filler comprises at least one of glass fiber, an aluminum-based fiber, or fluoride fiber.

**6.** The optical film according to claim 1, wherein the filler comprises aluminum oxide hydroxide.

7. The optical film according to claim 1, wherein a content of the filler is 1 to 40 wt% based on a total weight of the optical film.

8. The optical film according to claim 1, wherein the optical film has a Vickers hardness (HV) of 42.5 or more based on a thickness of 50 μm.

9. The optical film according to claim 1, wherein the optical film has a yellowness index of 3 or less based on a thickness of 50 μm.

10. The optical film according to claim 1, wherein the optical film has a haze of 4% or less based on a thickness of 50 μm.

11. The optical film according to claim 1, wherein the optical film has a light transmittance of 88% or more based on a thickness of 50 μm.

12. The optical film according to claim 1, wherein the light-transmitting matrix comprises at least one of an imide repeating unit or an amide repeating unit.

13. A display device comprising:

a display panel; and
the optical film according to any one of claims 1 to 12 disposed on the display panel.

14. A method of manufacturing an optical film comprising:

primarily dispersing a filler in a resin solution for forming a polymer matrix to prepare a first mixed solution;
adjusting a pH of the first mixed solution to a range of 5 to 7 to improve arrangement characteristics of the filler in the first mixed solution;
casting the first mixed solution to prepare a cast film;
applying a pressure to the cast film; and
drying the cast film while heating at a heating rate of 1°C/1 minute from 80°C to 120°C,
wherein the filler has a fiber shape, and
the filler has B/A of 10 to 500, wherein the A represents a diameter of the filler and the B represents a length of the filler.

FIG. 1

100
110
120
S2
S1

FIG. 2

Example1
Comparative example1
Comparative example 3
Comparative example 4
Differential Hardness(MPa)
300
250
200
150
100
50
0
0
500
1000
1500
2000
Load(mN)

# FIG. 3

Example1
Comparative example1
Comparative example 3
Comparative example 4
A Area
B Area
C Area
D Area
Differential Hardness (MPa)
300
250
200
150
100
50
0
0
10
20
30
40
50
60
70
Depth (um)

FIG. 4

200
P
100
500

FIG. 5

P
570
571 572 573
580
100
110 120
590
501
552
551
510
541 520 530 542
535
TFT

**INTERNATIONAL SEARCH REPORT**

International application No.
**PCT/KR2024/018345**

**A. CLASSIFICATION OF SUBJECT MATTER**

**H10K 59/80**(2023.01)i; **B29C 39/14**(2006.01)i; **B29C 39/38**(2006.01)i; **B29C 39/00**(2006.01)i; **B29C 70/06**(2006.01)i; **C08J 5/18**(2006.01)i; **C08K 5/12**(2006.01)i; **C08K 7/02**(2006.01)i; **C08K 3/22**(2006.01)i

According to International Patent Classification (IPC) or to both national classification and IPC

**B. FIELDS SEARCHED**

Minimum documentation searched (classification system followed by classification symbols)

H10K 59/80(2023.01); B32B 27/28(2006.01); C08J 5/18(2006.01); C08K 3/013(2018.01); C08K 3/36(2006.01); C08K 7/08(2006.01); C08L 101/00(2006.01); C09D 17/00(2006.01); F21V 7/00(2006.01); G02B 5/02(2006.01); H10K 59/00(2023.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 광학 필름(optical film), 매트릭스(matrix), 필러(filler), 섬유 형상(fiber shape), 내압 지수(pressure resistance index), 차등 경도(differential hardness), 상승 변곡점(rising inflection point)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2023-0004443 A (TAIYO HOLDINGS CO., LTD.) 06 January 2023 (2023-01-06)<br>See paragraphs [0021], [0083], [0086]-[0087], [0101] and [0121]-[0122]; and claims 1, 3-4 and 6. | 1-14 |
| Y | KR 10-2022-0007548 A (KOLON INDUSTRIES, INC.) 18 January 2022 (2022-01-18)<br>See paragraphs [0028]-[0029], [0056], [0202] and [0208]; and claim 1. | 1-13 |
| Y | JP 2007-231213 A (TORAY INDUSTRIES, INC.) 13 September 2007 (2007-09-13)<br>See abstract; and claims 1 and 3. | 14 |
| A | KR 10-2014-0076892 A (GL KOREA CO., LTD.) 23 June 2014 (2014-06-23)<br>See paragraphs [0018]-[0020]; and figure 1. | 1-14 |
| A | KR 10-2021-0148237 A (AJINOMOTO CO., INC.) 07 December 2021 (2021-12-07)<br>See paragraphs [0120] and [0051]-[0056]; and claims 1 and 6. | 1-14 |

☑ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **05 March 2025** | **05 March 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

INTERNATIONAL SEARCH REPORT

International application No.
**PCT/KR2024/018345**

**C. DOCUMENTS CONSIDERED TO BE RELEVANT**

| Category* | Citation of document, with indication, where appropriate, of the relevant passages | Relevant to claim No. |
|---|---|---|
| PX | KR 10-2024-0011102 A (KOLON INDUSTRIES, INC.) 25 January 2024 (2024-01-25) See claim 21. | 14 |

Form PCT/ISA/210 (second sheet) (July 2022)

**INTERNATIONAL SEARCH REPORT**
**Information on patent family members**

International application No.
**PCT/KR2024/018345**

| Patent document cited in search report | Publication date (day/month/year) | Patent family member(s) | Publication date (day/month/year) |
|---|---|---|---|
| KR 10-2023-0004443 A | 06 January 2023 | CN 115461411 A | 09 December 2022 |
| | | TW 202206547 A | 16 February 2022 |
| | | WO 2021-221118 A1 | 04 November 2021 |
| KR 10-2022-0007548 A | 18 January 2022 | CN 115803385 A | 14 March 2023 |
| | | CN 115803385 B | 15 October 2024 |
| | | JP 2023-533275 A | 02 August 2023 |
| | | JP 7617241 B2 | 17 January 2025 |
| | | KR 10-2688950 B1 | 26 July 2024 |
| | | TW 202204504 A | 01 February 2022 |
| | | TW I795837 B | 11 March 2023 |
| | | US 2023-0257532 A1 | 17 August 2023 |
| | | WO 2022-010298 A1 | 13 January 2022 |
| JP 2007-231213 A | 13 September 2007 | JP 5151042 B2 | 27 February 2013 |
| KR 10-2014-0076892 A | 23 June 2014 | None | |
| KR 10-2021-0148237 A | 07 December 2021 | CN 113631619 A | 09 November 2021 |
| | | CN 113631619 B | 27 February 2024 |
| | | JP 2020-164699 A | 08 October 2020 |
| | | JP 7215300 B2 | 31 January 2023 |
| | | WO 2020-203750 A1 | 08 October 2020 |
| KR 10-2024-0011102 A | 25 January 2024 | KR 10-2024-0011103 A | 25 January 2024 |
| | | KR 10-2647312 B1 | 13 March 2024 |
| | | KR 10-2698935 B1 | 26 August 2024 |
| | | TW 202411304 A | 16 March 2024 |
| | | TW 202413491 A | 01 April 2024 |
| | | WO 2024-019468 A1 | 25 January 2024 |
| | | WO 2024-019472 A1 | 25 January 2024 |

Form PCT/ISA/210 (patent family annex) (July 2022)